# EUROPEAN PATENT APPLICATION

(11) **EP 4 733 775 A1**
(43) Date of publication of application: **29.04.2026**
(21) Application number: 25205984.5
(22) Date of filing: 01.10.2025
(51) Int. Cl.: G01R 1/04, G01R 15/18, H01F 38/30

(54) **MOUNTING SYSTEM FOR A CURRENT SENSOR**

(30) Priority: 24.10.2024 US 202463711302 P
(71) Applicant: Eaton Intelligent Power Limited, Dublin 4, D04 Y0C2 (IE)
(72) Inventor: Reed, Samuel, Hartland (US)
(74) Representative: Collingwood-Pierce, Alexandra Isobel Seymour

(57) **Abstract**

A system (120) includes: an electrical apparatus including a circuit (124); a sensor mount (160) including: a rigid base (162) including a bottom side, an inner side (164) that defines an opening (165), an outer side (163), and a region (166) configured to receive an AC current sensor; and a bushing (140) including: an electrically insulating body (142), and an electrical conductor (144) that passes through a wall (123) of the electrical apparatus and is configured to be electrically connected to the circuit. The rigid base is attached to the wall with the bushing extending through the opening.

## Description

### TECHNICAL FIELD

This disclosure relates to a mounting system for a current sensor, such as a Rogowski coil.

### BACKGROUND

Current sensors are used to measure alternating electrical current (AC current) that flows in a conductor. The measured current may be used to monitor current flow to and/or from an electrical apparatus, such as a transformer.

### SUMMARY

In one aspect, a system includes: an electrical apparatus including a circuit; a sensor mount including: a rigid base including a bottom side, an inner side that defines an opening, an outer side, and a region configured to receive an AC current sensor; and a bushing including: an electrically insulating body, and an electrical conductor that passes through a wall of the electrical apparatus and is configured to be electrically connected to the circuit. The rigid base is attached to the wall with the bushing extending through the opening.

Implementations may include one or more of the following features.

The region may be configured to receive one of a Rogowski coil and a low power current transformer (LPCT).

The region may include a recess configured to receive the AC current sensor; and the sensor mount also may include a top portion configured to attach to the rigid base, and, when the top portion is attached to the rigid base, the top portion covers at least part of the recess. The top portion may include: a first top portion configured to attach to a first part of the rigid base; and a second top portion configured to attach to a second part of the rigid base. Each of the first top portion and the second top portion may be a part of an annulus, and the rigid base may be an annulus. The first top portion may snap onto to one or more distinct points on the first part of the rigid base, and the second top portion may snap onto one or more distinct points on the second part of the rigid base. The first top portion may include one or more mounting elements configured to interact with one or more corresponding mounting elements on the first part of the rigid base to attach the first top portion to the first part of the rigid base; and the second top portion may include one or more mounting elements configured to interact with one or more corresponding mounting elements on the second part of the rigid base to attach the second top portion to the second part of the rigid base.

The bushing also may include a clamp that secures the electrically insulating body to the wall, and the rigid base may be attached to the wall by being attached to the clamp.

The opening may be circular and the region may be an annulus; and, in these implementations, the opening, the region, and the electrical conductor are concentric.

The region may have a center point and the electrical conductor may pass through the center point.

The system also may include a housing that defines an interior, and, in these implementations, the circuit is in the interior, the wall is one side of the housing, the wall has a first side that faces the interior, a second side that faces away from the interior, and the rigid base is attached to the second side of the wall. The interior may be configured to receive an electrically insulating fluid.

The electrical apparatus may be one of a transformer and a switchgear.

In another aspect, an apparatus includes: a base that includes: a bottom side; an inner side that defines an opening configured to be positioned on a bushing of an electrical apparatus; an outer side; and a region opposite the bottom side, the region may be configured to receive an AC current sensor; a first top portion configured to attach to one or more distinct points on a first part of the base; and a second top portion configured to attach to one or more distinct points on a second part of the base.

Implementations may include one or more of the following features.

The bottom side may include one or more attachment elements configured to be fixedly attached to a bushing clamp of the bushing.

The inner side may include a first curved wall, the outer side may include a second curved wall, and at least a portion of the region that is configured to receive the AC current sensor may be bounded by the first curved wall and the second curved wall.

The region may be configured to receive one of a Rogowski coil and a low power current transformer (LPCT).

In another aspect, a sensor mount includes: a base including: a bottom side configured to be fixedly attached to a bushing; and a region opposite the bottom side, the region configured to receive an AC current sensor, and, when the base is fixedly attached to the bushing, the region is concentric with an electrical conductor in the bushing. The sensor mount also includes a plurality of portions configured to be removed and attached to a different part of the base repeatedly such that the region is accessible without removing the base from the bushing.

Implementations may include one or more of the following features.

The base includes a circular ring, and each of the plurality of portions is a part of an annulus.

The bottom side includes configured to be attached to a bushing clamp.

The base may include an inner curved wall and an outer curved wall, and the region is between the inner curved wall and the outer curved wall.

Implementations of any of the techniques described herein may include a system, an apparatus, or a method. The details of one or more implementations are set forth in the accompanying drawings and the description below. Other features will be apparent from the description and drawings, and from the claims.

### DRAWING DESCRIPTION

FIG. 1A is a side cross-sectional view of an electrical system.
FIG. 1B is a front view of the electrical system of FIG. 1A.
FIG. 2 is a side-cross sectional view of a bushing.
FIG. 3A is a perspective view of a sensor mount in an assembled state.
FIG. 3B shows an upper side of a base of the sensor mount of FIG. 3A.
FIG. 3C shows an underside of a first top portion of the sensor mount of FIG. 3A.
FIG. 3D shows an underside of a second top portion of the sensor mount of FIG. 3A.
FIG. 4 shows an upper side of a base of another sensor mount.

### DETAILED DESCRIPTION

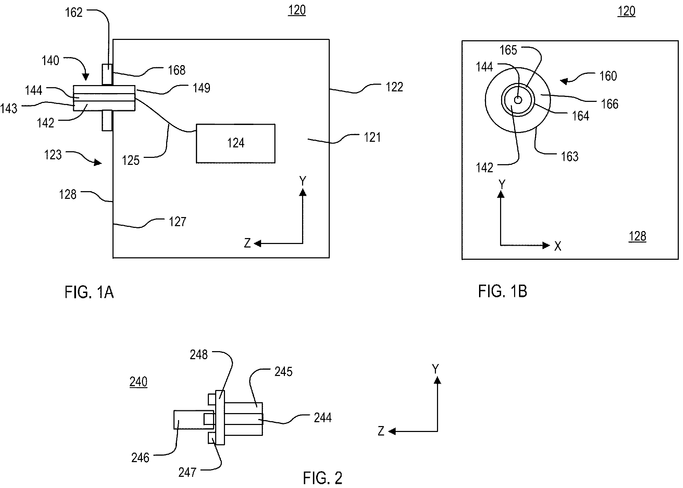

FIG. 1A is a side cross-sectional view of an electrical system 120, and FIG. 1B is a front view of the electrical system 120. The electrical system 120 includes a sensor mount 160. The sensor mount 160 is fixedly attached to an exterior side 128 of the electrical system 120 and holds a current sensor (such as a Rogowski coil). As discussed below, the sensor mount 160 is a robust mounting system that secures the current sensor during transport of the electrical system 120 and improves the accuracy of the current sensor during use. For example, the sensor mount 160 is designed to remain attached to the electrical system 120 even when experiencing vibrations and mechanical motions that are equivalent to up to seismic zone 4 earthquake or seismic activity. Moreover, the sensor mount 160 may be used instead of current sensors (such as current transformers) inside the electrical system 120. Eliminating or removing current sensors inside the electrical system 120 may reduce the size, weight, cost, and/or complexity of the electrical system 120.

The electrical system 120 may be, for example, a transformer, a voltage regulator, a recloser, or switchgear. The electrical system 120 may be rated for voltages between, for example, 15 kilovolts (kV) and 38 kV, or up to 46 kV and for continuous current of, for example, up to 900 amperes (A), up to 1200 A, or up to 6500 A. The electrical system 120 may be part of an AC electrical grid or electrical power distribution system that includes one or more distribution lines, electrical cables, and/or any other mechanism for transmitting electricity. The electrical power distribution system may have an operating voltage of, for example, up to 120 V, up to 600 V, at least 1 kV, up to 34.5 kV, up to 38 kV, or up to 46 kV, and may operate at a fundamental frequency of, for example, 50 or 60 Hertz (Hz).

The electrical system 120 includes a housing 122 that has an interior 121 and an electrical circuit 124 in the interior 121. The electrical circuit 124 may include, for example, a switch (such as a vacuum interrupter or a circuit breaker), an electrical coil, a magnetic core, or a combination of such devices. The electrical circuit 124 may be an electromagnetic circuit that includes magnetic aspects. For example, the electrical circuit 124 may include one or more electrically conductive coils wrapped around a magnetic core.

The housing 122 may be, for example, a tank, compartment, cabinet, frame, or vault. The housing 122 may completely enclose the interior 121. For example, the housing 122 may be a sealed tank that contains an electrically insulating fluid, such as transformer oil, vegetable oil, or mineral oil. In other examples, the housing 122 does not completely enclose the interior 121 or may include a door or other movable portion that allows an end user or installer to enclose or open the interior 121. The housing 122 is made of a durable material such as, for example, steel.

Regardless of its specific form, the housing 122 includes a wall 123 and a bushing 140 that extends through the wall 123. The wall 123 includes a first side 127 that faces the interior 121 and a second side 128 that faces away from the interior 121. The bushing 140 includes an electrically insulating body 142 that extends from a first end 149 to a second end 143 and surrounds an electrical conductor 144. The electrically insulating body 142 insulates the electrical conductor 144 from the wall 123 such that the electrical conductor 144 can pass through the wall 123 without unintentionally electrically connecting to the wall 123 or other electrically conductive elements in the vicinity. The electrically insulating body 142 also allows a connector (such as an elbow connector or a T-shaped connector) to attach to the second end 143. In this way, the bushing 140 allows the electrical circuit 124 to be electrically connected to an external device or node. The electrical conductor 144 and the body 142 are substantially concentric. The conductor 144 is electrically connected to the electrical circuit 124 by a conductive path 125. The conductive path 125 may be, for example, an electrical cable or wire.

The bushing 140 may be a high-voltage bushing or a low-voltage bushing. High-voltage bushings include, for example, deadfront bushings rated for voltages from 15kV to 46kV and amperages from 200 A to 900 A. Low-voltage bushings include, for example, bushings rated for 1.1kV or less and up to 5 kV and amperages from 1200 A to 6500A. FIG. 2 is a side cross-sectional view of a bushing 240. The bushing 240 is an example of a bushing that may be used as the bushing 140. The bushing 240 includes a bushing well 245 with an electrical conductor 244, a bushing insert 246, and a bushing clamp 248. When installed in the wall 123, the bushing well 245 extends into the interior 121. The bushing insert 246 fits into the bushing well 245 and extends through the wall 123 to the exterior of the housing 122. The bushing clamp 248 is mounted on the second side 128 of the wall 123 and seals the bushing well 245 to the wall 123. The bushing clamp 248 includes one or more studs or clamps 247 that attach the bushing clamp 248 to the wall 123 and extend generally outward from the second side 128 (in the Z direction in FIGS. 1A, 1B, and 2).

The bushing 240 is shown as an example, and bushings having other configurations may be used with the electrical apparatus 120 and the sensor mount 160. For example, the bushing 240 may be considered to be a two-piece bushing because it includes the bushing well 245 and the bushing insert 246. However, a one-piece bushing or integral bushing that includes the functionality of the bushing well 245 and the bushing insert 246 in a single, integral piece also may be used with the electrical apparatus 120 and the sensor mount 160.

The sensor mount 160 includes a base 162 that is attached to the second side 128. The base 162 is a rigid body that includes a bottom side 168, an inner side 164 that defines an opening 165, and an outer side 163. The base 162 is made of a rigid material such as, for example, a hardened plastic or polymer material. The base 162 may be an injected molded plastic. The base 162 also includes a region 166 between the inner side 164 and the outer side 163. The opening 165 is circular and the region 166 is an annulus or ring. The spatial center of the region 166 and spatial center of the opening 165 are co-located.

The region 166 is configured to receive a current sensor such as a Rogowski coil or a low-power current transformer (LPCT). A Rogowski coil is a sensor that measures alternating current or time-varying current. The Rogowski coil may include a wound electrical conductor (such as a metal wire) that is formed into a circular coil. To measure AC current that flows in a conductor, the circular coil is placed around the conductor. The magnetic field produced by the AC current induces a voltage in the circular coil, and the Rogowski coil produces a voltage that is proportional to the rate of change (derivative) of the current enclosed by the circular coil. The coil voltage is then integrated to provide an output voltage that is proportional to the AC current flowing in the conductor. The output voltage may be used to detect fault conditions and/or monitor conditions in the electrical system 120. The measurements from a Rogowski coil are generally most accurate when the conductor is at the spatial center of the circular coil.

The region 166 can receive any form of AC current sensor. For example, the region 166 may receive a rope Rogowski coil, which a flexible wire sensor. In another example, the region 166 may receive a rigid Rogowski coil that has the size and shape of the region 166. An example of a rigid Rogowski coil is one that is implemented as a conductive trace on a printed circuit board (PCB) or another rigid substrate. In yet another example, the region 166 can receive an LPCT.

The region 166 may be a recess or channel. For example, the inner side 164 and the outer side 163 may include walls or sides that extend out from the base 162 in the Z direction to form a channel, recess, or bounded space between the inner side 164 and the outer side 163. In some implementations, the region 166 is unbounded. The AC current sensor may be held in the region 166 by a pressure or press fit. For example, the region 166 may have a size that is just slightly larger than the AC current sensor such that the AC current sensor is held by the boundary of the region 166. Additionally, or alternatively, the base 162 may include one or more fasteners (for example, clamp(s) and/or zip tie(s)) to hold the AC current sensor in the region 166.

The base 162 is attached to the second side 128 of the wall 123 with the bushing 140 extending through the opening 165. The base 162 is fixedly attached to the second side 128 and does not move relative to the second side 128. The base 162 may be mounted directly to the wall 123. For example, the bottom side 168 of the base 162 may be glued or cemented to the second side 128. In some implementations, the base 162 is indirectly attached to the wall 123. For example, in implementations in which the bushing 240 is used as the bushing 140, the bottom side 168 may placed on the bushing clamp 248 with the studs 247 extending through corresponding openings on the base 162. The base 162 is then secured onto the bushing clamp 248. For example, the studs 247 may be threaded and the base 162 may be secured to the bushing clamp 247 by threading a nut onto each stud 247 to secure the base 162 between the nut and the bushing clamp 247.

Because the region 166 is concentric with the opening 165 and the conductor 144 is concentric with the bushing 140, when the base 162 is attached to the wall 123, the conductor 144 of the bushing 140 is also concentric with the region 166. Thus, when the Rogowski coil is positioned in the region 166, the spatial center of the circular coil of the Rogowski coil coincides with the conductor 144. In this way, the sensor mount 160 helps to ensure that the data measured by a Rogowski coil that is placed in the region 166 accurately reflects the amount of current flowing in the conductor 144. Additionally, because the base 162 is fixedly attached, directly or indirectly, to the wall 123, the base 162 and the Rogowski coil in the region 166 remain stationary during use, further improving the accuracy of the measured data. The base 162 and the Rogowski coil in the region 166 also remain stationary during transport, allowing the Rogowski coil to be installed in the sensor mount 160 by the manufacturer of the electrical system 120 and shipped in the assembled state without damage.

Moreover, the sensor mount 160 may allow the electrical system 120 to be smaller, lighter, and/or less expensive then legacy electrical systems that rely on internal current sensors while still providing the same or greater fault protection and current monitoring. For example, some legacy electrical systems (such as transformers and switchgear) include current transformers inside the tank. These current transformers are used to measure current flow in the transformer and are typically large and bulky. On the other hand, the sensor mount 160 allows an AC current sensor (such as a Rogowski coil or LPCT) to perform the function of the current transformers outside of the housing 122. Thus, in implementations in which the electrical system 120 is a transformer, the interior 121 does not necessarily include current transformers. This allows the interior 121 to be smaller than a legacy electrical system, thereby reducing the footprint of the electrical system and reducing the amount of electrically insulating fluid used in the electrical system. Furthermore, by removing the current transformers from the interior and placing the current sensing mechanism outside of the interior, the electrical system 120 is easier to manufacture and simpler to repair than a legacy system.

Other implementations of the electrical system 120 are possible. For example, only one bushing is shown in FIGS. 1A and 1B. However, the electrical system 120 may have more than one bushing. For example, the electrical system 120 may be a three-phase device with one electrical circuit 124 and two bushings (one input bushing and one output bushing) per phase. In another example, the bushing clamp 247 may include three studs 247 or four studs 247.

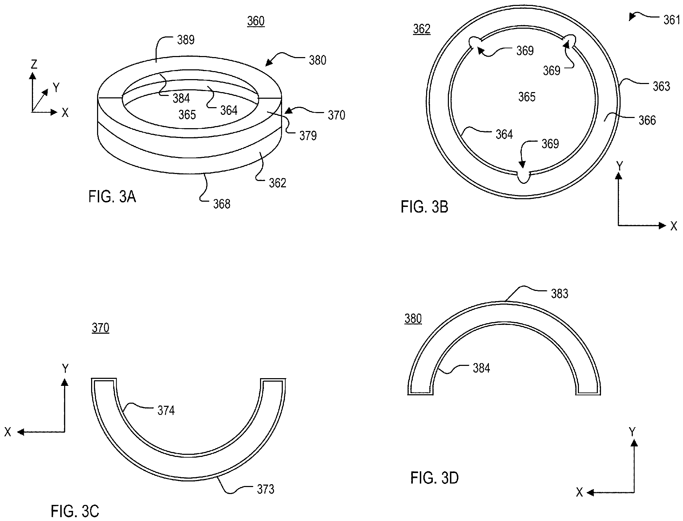

FIGS. 3A-3D relate to a sensor mount 360. The sensor mount 360 may be used with the electrical system 120. FIG. 3A is a perspective view of the sensor mount 360 in an assembled state. The sensor mount 360 includes a base 362, a first top portion 370, and a second top portion 380. The base 362 includes a bottom side 368. The first top portion 370 and the second top portion 380 are attached to an upper side 361 of the base 362 that is opposite the bottom side 368. Each of the first top portion 370 and the second top portion 380 has a respective top surface 379, 389. The first top portion 370 is attached to a first part of the base 362 and the second top portion 380 is attached to a second part of the base 362. In the example shown, the base 362 is a circular ring and each of the top portions 370 and 380 is a half annulus that fits onto a first half and second half, respectively, of the base 362.

The top portions 370 and 380 are configured to be repeatedly removed from and attached to the base 362 without damaging the top portions 370 and 380 or the base 362. For example, each top portion 370 and 380 may include mounting elements that attach to corresponding mounting elements on the base 362 with a snap connection or a frictional engagement. Examples of mounting elements include, without limitations, tabs and corresponding slots, clips and corresponding protrusions, and/or pegs or posts and corresponding recesses. In some implementations, mechanical fasteners (such as screws, zip ties, and/or a hook and loop fabric-based fastener such as VELCRO) are used to secure the top portions 370 and 380 to the base 362.

The base 362 and the top portions 370, 380 are rigid bodies made of a solid material, such as plastic. However, although the base 362 and the top portions 370, 380 are generally rigid and maintain their shape over time, the base 362 and the top portions 370, 380 may include some flexible components (such as tabs) that are capable of small movements and/or deformations. For example, the top portion 370 may include a tab configured to deform or move away from its equilibrium position during insertion into a corresponding slot on the base 362 and to then snap into the slot to temporarily secure the top portion 370 to the base 362.

FIG. 3B shows the upper side 361 of the base 362 with the first and second top portions 370, 380 removed. The base 362 includes an inner side 364 that defines an opening 365 and an outer side 363. The inner side 364 and the outer side 363 include wall-like structures that extend in the Z direction (out of the page in FIG. 3B). The inner side 364 also includes connection points 369, which are used to attach the base 362 to a bushing clamp (such as the bushing clamp 248 of FIG. 2). The opening 365 is a substantially a circle. The base 362 also includes a region 366 between the inner side 364 and the outer side 363. The region 366 is configured to receive a Rogowski coil. The region 366 is a circular ring that is concentric with the inner side 364. The region 366 is substantially flat in the X-Y plane.

FIG. 3C shows an underside of the first top portion 370 and FIG. 3D shows an underside of the second top portion 380. The underside of the first top portion 370 is opposite to the top surface 379. The underside of the second top portion 380 is opposite to the top surface 389. The first top portion 370 includes an outer side 373 and an inner side 374. The second portion 380 includes an outer side 383 and an inner side 384. The outer sides 373 and 383 and the inner sides 374 and 384 are walls that have the same curvature as the outer side 363 and inner side 364, respectively.

To attach the sensor mount 360 to an electrical system that includes the bushing 240 (FIG. 2), the base 362 is positioned over the insert 346 and moved toward the bushing clamp 247 until each stud 247 is received in one of the connection points 369. A nut or other fastener is placed on the stud 247 to capture the base 362 between the nut and the bushing clamp 247. The bottom side 368 faces the bushing clamp 247 and the region 366 faces away from the bushing clamp 247. An AC current sensor, such as a Rogowski coil or LPCT (not shown), is placed in the region 366. The first top portion 370 is positioned on the first half of the upper side 361 of the base 362 and is secured to the base 362 by frictional engagement, a snap fit, and/or mechanical fasteners. The second top portion 380 is positioned on the second half of the upper side 361 of the base 362 and is secured to the base 362 by frictional engagement, a snap fit, and/or mechanical fasteners.

When both top portions 370, 380 are attached to the base 362, the Rogowski coil is enclosed in the sensor mount 360 and is concentric with the conductor 244. However, the assembled sensor mount 360 may have passages (not shown) to allow for air flow, signal wire connections, and/or control wire connections. Thus, the Rogowski coil is protected within the assembled sensor mount 360 but is not necessarily completely sealed off from the surrounding environment or fully enclosed by the assembled sensor mount 360. Furthermore, due to the two-part design and removable nature of the top portions 370, 380, the Rogowski coil can be replaced or repaired without removing the bushing 240 or otherwise disturbing the electrical system.

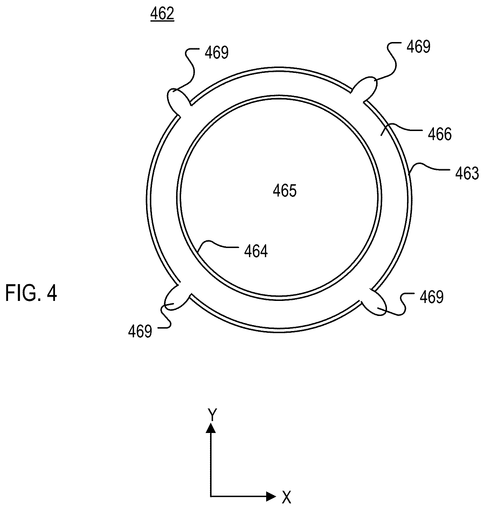

The configuration shown in FIGS. 3A-3D is provided as an example and other implementations are possible. For example, the first and second top portions 370, 380 may be a shape other than a half-annulus and are not necessarily the same shape. In some implementations, the first top portion 370 is a quarter of a circular annulus and the second top portion is three-quarters of a circular annulus. In some implementations, more than two top portions are used. For example, three top portions, each approximately a third of a circular annulus, may be used. Moreover, other shapes are possible. For example, sensor mount 360 may have a square or rectangular perimeter with a circular region 366 inside. Furthermore, and as shown in FIG. 4, the base 362 may include more or fewer connection points 369 to facilitate mounting to different designs of bushing clamps.

FIG. 4 shows an upper side of another base portion 462. The base portion 462 includes an outer side 463, an inner side 464 that defines an opening 465, and a region 466 for receiving an AC current sensor, such as a Rogowski coil or a LPCT, between the outer side 463 and the inner side 464. The region 466 is concentric with the opening 465. The base portion 462 also includes four connection points 469 that extend radially outward from the outer side 463. The four connection points 469 are circumferentially spaced at equal intervals (90°). The four connection points 469 are arranged to be mounted onto a bushing clamp that has four studs. The base portion 462 may be used with top portions such as the top portions 370 and 380 to enclose a Rogowski coil in the region 466.

These and other features are within the scope of the claims.

## Claims

1. A system comprising:
an electrical apparatus comprising a circuit;
a sensor mount comprising:
a rigid base comprising a bottom side, an inner side that defines an opening, an outer side, and a region configured to receive an AC current sensor; and
a bushing comprising: an electrically insulating body, and an electrical conductor that passes through a wall of the electrical apparatus and is configured to be electrically connected to the circuit, wherein the rigid base is attached to the wall with the bushing extending through the opening.

2. The system of claim 1, wherein the region is configured to receive one of a Rogowski coil and a low power current transformer (LPCT).

3. The system of claim 1, wherein the region comprises a recess configured to receive the AC current sensor; and the sensor mount further comprises a top portion configured to attach to the rigid base, and, when the top portion is attached to the rigid base, the top portion covers at least part of the recess, wherein the top portion comprises:
a first top portion configured to attach to a first part of the rigid base; and
a second top portion configured to attach to a second part of the rigid base.

4. The system of claim 3, wherein each of the first top portion and the second top portion are a part of an annulus, and the rigid base is an annulus.

5. The system of claim 3, wherein the first top portion snaps onto to one or more distinct points on the first part of the rigid base, and the second top portion snaps onto one or more distinct points on the second part of the rigid base.

6. The system of claim 3, wherein the first top portion comprises one or more mounting elements configured to interact with one or more corresponding mounting elements on the first part of the rigid base to attach the first top portion to the first part of the rigid base; and the second top portion comprises one or more mounting elements configured to interact with one or more corresponding mounting elements on the second part of the rigid base to attach the second top portion to the second part of the rigid base.

7. The system of claim 1, wherein the bushing further comprises a clamp that secures the electrically insulating body to the wall, and wherein the rigid base is attached to the wall by being attached to the clamp.

8. The system of claim 1, wherein the opening is circular and the region is an annulus; and the opening, the region, and the electrical conductor are concentric.

9. The system of claim 1, further comprising a housing that defines an interior, and wherein the circuit is in the interior, the wall is one side of the housing, the wall has a first side that faces the interior, a second side that faces away from the interior, and the rigid base is attached to the second side of the wall, wherein the interior is configured to receive an electrically insulating fluid.

10. The system of claim 1, wherein the electrical apparatus is one of a transformer and a switchgear.

11. An apparatus comprising:
a base comprising: a bottom side; an inner side that defines an opening configured to be positioned on a bushing of an electrical apparatus; an outer side; and a region opposite the bottom side, wherein the region is configured to receive an AC current sensor;
a first top portion configured to attach to one or more distinct points on a first part of the base; and
a second top portion configured to attach to one or more distinct points on a second part of the base.

12. The apparatus of claim 11, wherein the bottom side comprises one or more attachment elements configured to be fixedly attached to a bushing clamp of the bushing.

13. The apparatus of claim 11, wherein the inner side comprises a first curved wall, the outer side comprises a second curved wall, and at least a portion of the region that is configured to receive the AC current sensor is bounded by the first curved wall and the second curved wall.

14. The apparatus of claim 11, wherein the region is configured to receive one of a Rogowski coil and a low power current transformer (LPCT).

15. A sensor mount comprising:
a base comprising: a bottom side configured to be fixedly attached to a bushing; and a region opposite the bottom side, the region configured to receive an AC current sensor, wherein, when the base is fixedly attached to the bushing, the region is concentric with an electrical conductor in the bushing; and
a plurality of portions configured to be removed and attached to a different part of the base repeatedly such that the region is accessible without removing the base from the bushing.
